# EUROPÄISCHE PATENTSCHRIFT

(11) **EP 2 062 294 B1**
(45) Veröffentlichungstag und Bekanntmachung des Hinweises auf die Patenterteilung: **03.04.2019**
(21) Anmeldenummer: 06791388.9
(22) Anmeldetag: 14.09.2006
(51) Int. Cl.: H01L 23/02, H01L 23/04, H01L 23/16, H01L 25/07, H01L 23/60

(54) **LEISTUNGSHALBLEITERMODUL MIT SCHUTZ IM EXPLOSIONSFALL**
POWER SEMICONDUCTOR MODULE COMPRISING PROTECTION IN CASE OF EXPLOSION
MODULE À SEMI-CONDUCTEUR DE PUISSANCE COMPRENANT UNE PROTECTION EN CAS D'EXPLOSION

(43) Veröffentlichungstag der Anmeldung: 27.05.2009
(73) Patentinhaber: Siemens Aktiengesellschaft, 80333 München (DE); Fraunhofer-Gesellschaft zur Förderung der angewandten Forschung e.V., 80686 München (DE)
(72) Erfinder: BILLMANN, Markus, 91448 Emskirchen (DE); DORN, Jörg, 96155 Buttenheim (DE)
(74) Vertreter: Maier, Daniel Oliver
(86) Internationale Anmeldenummer: PCT/DE2006/001641
(87) Internationale Veröffentlichungsnummer: WO 2008/031372

(56) Entgegenhaltungen:
- EP-A- 1 768 182
- EP-A1- 0 033 399
- DE-A1- 10 306 767
- DE-A1- 19 839 422
- JP-A- 2004 294 025
- US-A- 4 162 514
- MORI T ET AL: "A new interruption method for low-voltage, high-capacity, air-break contactors suppressing the blowoff of a hot gas" PROCEEDINGS OF THE INDUSTRY APPLICATIONS SOCIETY ANNUAL MEETING. DEARBORN, SEPT. 28 - OCT. 1, 1991, NEW YORK, IEEE, US, Bd. VOL. 2, 28. September 1991 (1991-09-28), Seiten 1692-1698, XP010056132 ISBN: 0-7803-0453-5

## Beschreibung

Die Erfindung betrifft ein Leistungshalbleitermodul für die Energieverteilung mit wenigstens einem Leistungshalbleiter, Anschlussklemmen zum Anschluss des Leistungshalbleitermoduls und einem Gehäuse.

Ein solches Leistungshalbleitermodul der ist aus der DE 98 39 422 bereits bekannt. Dort ist ein Explosionsschutz für Halbleitermodule offenbart, wobei der Halbleiter in einer Schutzhülle angeordnet ist, die Fragmente, die bei einer Explosion des Leistungshalbleiters weggeschleudert werden, auffängt. Auf diese Weise soll verhindert werden, dass Personen oder benachbarte Bauteile durch die Explosion beschädigt werden. Nachteilig bei dem vorbekannten Leistungshalbleiterbauelement ist, dass der Explosionsschutz nicht geeignet ist, beim Auftreten eines Lichtbogens einen ausreichenden Schutz zu gewährleisten.

DE 103 06 767 A1 betrifft ein Halbleitermodul mit einem Halbleiterelement und zwei Anschlusselektroden, zwischen denen das Halbleiterelement angeordnet und mit denen es elektrisch leitend kontaktiert ist, wobei das Halbleiterelement von einem wenigstens teilweise elektrisch isolierenden Gehäuse umgeben ist, welches zum Schutz des Gehäuses vor der Auswirkung von bei Überlast auftretenden Lichtbögen im Inneren des Moduls ein hochtemperaturfester Isolator vorgesehen ist, der wenigstens stellenweise zwischen einer Wand des Gehäuses und dem Halbleiterelement angeordnet ist. Der Isolator kann das Halbleiterelement als Hohlzylinder umgeben.

US 4,162,514 betrifft eine Anordnung für Halbleiter-Leistungskomponenten in einer Einrichtung, in welcher zumindest eine Halbleiter-Leistungskomponente zwischen Kontaktstücken positioniert ist und in einem Gehäuse aufgenommen ist, das einen Isolator und Verbindungsstücke aufweist. Die Anordnung umfasst Stromleiter, welche die Sicherheit fördern und eine Explosion verhindern, indem sie in der Anlage gebildete Lichtbögen aufnehmen. Die Stromableiter befinden sich lateral benachbart zu den Kontaktstücken und sind die letzteren ringförmig umgebend positioniert, und zwar von der Innenwand des Isolators durch schmale Spalte getrennt. Zusätzliche Ausführungsformen verwenden Verstärkungselemente um das Gehäuse herum sowie einen Explosionsschutz um das Gehäuse herum, wodurch die Anlagensicherheit weiter verbessert wird.

Aus der EP 1 768 182 A2, die nachveröffentlichten Stand der Technik darstellt, ist ein Leistungshalbleitermodul der eingangs genannten Art bekannt, der eine Sicherungseinrichtung zum Explosionsschutz bereitstellt. Die Sicherungseinrichtung ist innerhalb des Gehäuses des Leistungshalbleitermoduls angeordnet und umfasst ein Verbindungselement in Form von Bonddrähten mit verringertem Leitungsquerschnitt. Das Verbindungselement ist von einem Explosionsschutzmittel umhüllt und von einem Rahmen umgeben. Der Rahmen weist dabei eine Ausnehmung zur Befüllung der Sicherungseinrichtung mit dem Explosionsschutzmittel auf, wobei die Ausnehmung von außerhalb des Gehäuses zugänglich ist.

Aufgabe der Erfindung ist es daher, ein Leistungshalbleitermodul der eingangs genannten Art bereitzustellen, mit dem ein Explosionsschutz auch beim Auftreten von Lichtbögen bereitgestellt ist.

Die Erfindung löst diese Aufgabe durch ein Leistungshalbleitermodul mit den Merkmalen des Anspruchs 1. Erfindungsgemäß sind jeder Leistungshalbleiter und jede Anschlussklemme in dem Gehäuse angeordnet, jede Anschlussklemme dabei bis auf ihre freien Enden, wobei das Gehäuse einen nach außen führenden Abgaskanal zum kontrollierten Abführen von Heißgasen und/oder Plasma im Explosionsfall aufweist.

Erfindungsgemäß ist nicht nur der eigentliche Leistungshalbleiter in einem Bauteil angeordnet. Vielmehr sind sämtliche

Komponenten der Leistungshalbleiterelektronik in dem Gehäuse angeordnet, wobei das Gehäuse selbst auch Teil des Leistungshalbleitermoduls ist. Die Leistungshalbleiterelektronik umfasst beispielsweise sämtliche Leistungshalbleiter, also sämtliche steuerbaren Leistungshalbleiter und deren parallel geschalteten Freilaufdioden, sowie die Steuerungseinheiten zum Steuern der Leistungshalbleiter. Lediglich die freien Enden der Anschlussklemmen des Leistungshalbleitermoduls sind aus dem Gehäuse herausgeführt, um dieses an weitere Bauteile, beispielsweise an weitere Leistungshalbleitermodule gemäß der vorliegenden Erfindung anzuschließen. Ein Lichtbogen, der von einem der Leistungshalbleiter im Fehlerfall verursacht wird, entsteht daher innerhalb des Gehäuses und wird von dem Gehäuse nach außen abgeschirmt. Um die Explosionskräfte und die entstehenden Heißgase kontrolliert nach außen abzuführen, ist ein Abgaskanal nach außen vorgesehen. Dabei ist der Abgaskanal so geführt und seine Mündungen sind zweckmäßigerweise so positioniert, dass die austretenden Heißgase oder weg geschleuderten Fragmente weder benachbarte Bauteile noch Personen beschädigen können.

Erfindungsgemäß ist der Abgaskanal mit einem durchströmbaren temperaturfesten Füllstoff befüllt. Vorteilhafterweise weist dieser Füllstoff eine große innere Oberfläche auf. Durch den durchströmbaren temperaturfesten Füllstoff werden austretende Heißgase oder Plasma vor dem Austritt aus dem Abgaskanal von dem Füllstoff abgekühlt. Die Abkühlung ist umso größer, je größer die innere Oberfläche des Füllstoffes ist. Der Füllstoff hält ferner beschleunigte Partikel, die bei einer Explosion im Fehlerfall gebildet werden, zurück. Darüber hinaus ist durch den Füllstoff eine Druckentlastung bereitgestellt.

Bei einer diesbezüglich nicht erfindungsgemäßen Weiterentwicklung ist der temperaturfeste Füllstoff beispielsweise aus einer Keramik gefertigt. Die Keramik ist dabei zweckmäßigerweise so ausgebildet, dass in ihr eine Vielzahl von inneren Kanälen und durchgängigen Poren bereitgestellt ist, so dass die Keramik von dem Heißgas oder dem Plasma durchströmbar bleibt. Darüber hinaus ist die Keramik temperaturbeständig und auch in der Lage den bei Lichtbogenbildung entstehenden hohen Temperaturen weitestgehend schadenfrei standzuhalten.

Es ist ebenfalls denkbar, dass der temperaturfeste Füllstoff ein Metallschaum ist. Zweckmäßige Metallschäume sind auf dem Markt erhältlich und können als solche problemlos bezogen werden. Sie weisen eine große innere Oberfläche sowie ein geringes Gewicht auf. Darüber hinaus ist ihre thermische Kapazität so groß und Temperaturbeständigkeit ausreichend, um den hohen Plasmatemperaturen im Lichtbogenfall widerstehen zu können. Darüber hinaus sind Metallschäume widerstandsfähig, so dass Partikel wirkungsvoll zurückgehalten werden und darüber hinaus eine besonders hohe Druckentlastung gegeben ist.

Gemäß einer diesbezüglich zweckmäßigen nicht erfindungsgemäßen Weiterentwicklung ist der Metallschaum ein offenporiger Metallschaum. Durch die offenen Poren des Metallschaums ist eine ausreichende Durchströmbarkeit für die Heißgase und das Plasma gewährleistet, so dass eine Explosion des gesamten Gehäuses wirkungsvoll verhindert ist.

Erfindungsgemäß ist der temperaturfeste Füllstoff eine Metallwolle. Eine Metallwolle bildet ein so genanntes chaotisches Metallfadenknäuel aus und wird auch "Putzrasch" bezeichnet. Metallwolle wird häufig als Flammrückschlagsicherung eingesetzt und ist kostengünstiger als beispielsweise Metallschaum beziehbar.

Leistungshalbleiterzweiges und der Freilaufdioden die zweite Anschlussklemme auszubilden. Eine solche Schaltung ist auch als Marquardt-Schaltung bekannt geworden. Die Marquardt-Schaltung weist zwei Schaltzustände auf, wobei in einem ersten Schaltzustand die an den Anschlussklemmen abfallende Spannung gleich null und in einer zweiten Schaltstellung gleich der Spannung des Energiespeichers ist.

Abweichend davon verfügt das Leistungshalbleitermodul über eine erste Anschlussklemme, eine zweite Anschlussklemme, einen Energiespeicher und einen zwei in Reihe geschaltete steuerbare Leistungshalbleiter aufweisenden Leistungshalbleiterzweig in Parallelschaltung zum Energiespeicher, wobei jedem steuerbaren Leistungshalbleiter eine gegensinnige Freilaufdiode parallel geschaltet ist und der Verbindungspunkt des Kollektors eines ersten steuerbaren Leistungshalbleiters des Leistungshalbleiterzweiges und der Kathode der dem ersten steuerbaren Leistungshalbleiter zugeordneten gegensinnigen Freilaufdiode die erste Anschlussklemme und der Verbindungspunkt der steuerbaren Leistungshalbleiter des Leistungshalbleiterzweiges und der Freilaufdiode die zweite Anschlussklemme ausbilden. Dies ist eine alternative Ausgestaltung der Marquardt-Schaltung, welche im Wesentlichen die gleichen Eigenschaften aufweist.

Die Erfindung betrifft ferner ein Stromrichterventilzweig mit einer Reihenschaltung aus Leistungshalbleitermodulen gemäß einem der vorhergehenden Ansprüche.

Ferner betrifft die Erfindung einen Stromrichter mit einer Brückenschaltung aus den oben genannten Stromrichterventilzweigen.

Mit anderen Worten betrifft die Erfindung auch Stromrichter, die aus Reihenschaltungen von erfindungsgemäßen Leistungshalbleitermodulen zusammengesetzt sind. Solche Stromrichter werden auch Multilevel-Stromrichter genannt. Sie ermöglichen ein stufenweises Zu- und Abschalten der Spannungen der einzelnen Leistungshalbleitermodule und somit eine feinere und genauere Regelung der Spannung.

Weitere zweckmäßige Ausgestaltungen und Vorteile der Erfindung sind Gegenstand der nachfolgenden Beschreibung von Ausführungsbeispielen der Erfindung unter Bezug auf die Figuren der Zeichnung, wobei gleiche Bezugszeichen auf gleichwirkende Bauteile verweisen und wobei
- Figur 1: ein Ausführungsbeispiel von erfindungsgemäßen Stromrichterzweigen,
- Figur 2: eine Ersatzbilddarstellung eines Ausführungsbeispiels eines erfindungsgemäßen Leistungshalbleitermoduls und
- Figur 3: eine Ersatzbilddarstellung eines Ausführungsbeispiels eines erfindungsgemäßen Leistungshalbleitermoduls zeigen.
- Figur 4: zeigt ein Leistungshalbleitermodul, das viele Merkmale des erfindungsgemäßen Leistungshalbleitermoduls gemäß Anspruchs 1 aufweist, ohne Energiespeicher.

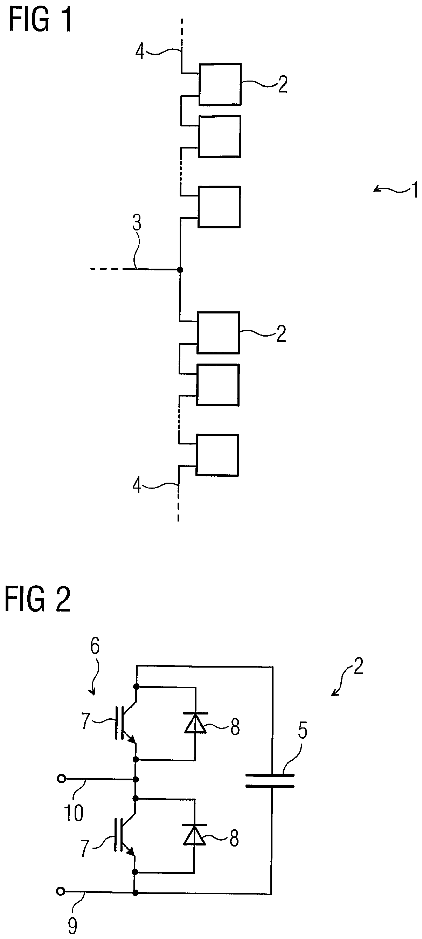

Figur 1 zeigt ein Ausführungsbeispiel von erfindungsgemäßen Stromrichterzweigen 1, die aus einer Reihenschaltung von Leistungshalbleitermodulen 2 bestehen. Dabei sind die Stromrichterventilzweige 1 in Reihe zueinander angeordnet. Die Anzahl der Leistungshalbleitermodule 2 innerhalb eines Stromrichterventilzweiges 1 richtet sich nach der jeweiligen Anwendung insbesondere nach den erforderlichen Spannungen. Die Anzahl kann daher zwischen einigen 10 bis zu mehreren 100 Leistungshalbleitermodulen 2 variieren.

Zwischen den Stromrichterventilzweigen 1 ist ein Wechselspannungsanschluss 3 vorgesehen, der zur Verbindung mit einer Phase eines Wechselspannungsnetzes vorgesehen ist. An dem vom Wechselspannungsanschluss 3 abgewandten Ende eines jeden Stromrichterventilzweiges 1 ist ein Gleichspannungsanschluss 4 vorgesehen. Somit ist jeder Stromrichterventilzweig 1 zwischen einem Wechselspannungsanschluss 3 und einem Gleichspannungsanschluss 4 angeordnet. Ein Ausführungsbeispiel eines erfindungsgemäßen Stromrichters bestünde bei einem anzuschließenden dreiphasigen Wechselspannungsnetz daher beispielsweise aus sechs Stromrichterventilzweigen, die in einer Brückenschaltung, die als solche bekannt ist, miteinander verschaltet ist. Hierbei kann es sich um eine so genannte Sechs-Puls-Brückenschaltung aber auch um eine Zwölf-Puls-Brückenschaltung handeln.

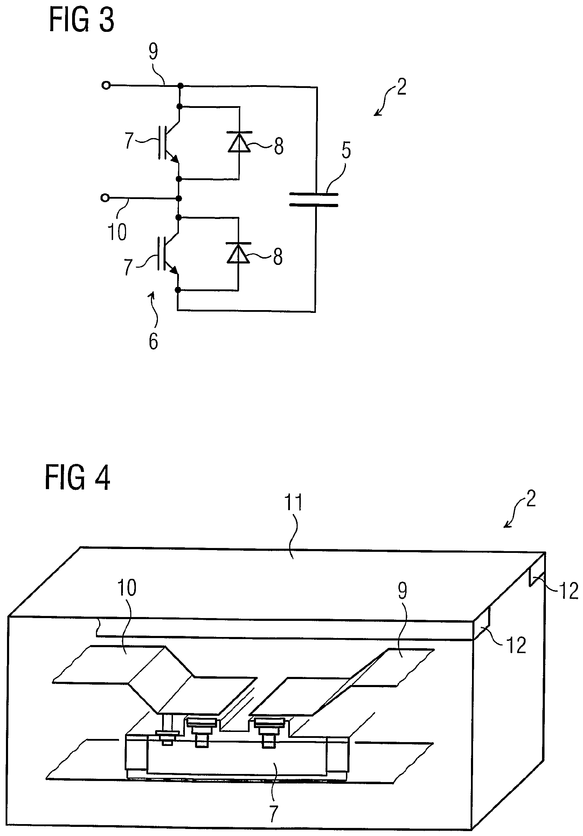

Figur 2 zeigt ein Ersatzschaltbild eines Ausführungsbeispiels eines erfindungsgemäßen Leistungshalbleitermoduls 2. Es ist erkennbar, dass jedes Leistungshalbleitermodul 2 einen Energiespeicher in Form eines Kondensators 5 aufweist. Der Kondensator 5 ist parallel zu einem Leistungshalbleiterzweig 6 geschaltet, wobei der Leistungshalbleiterzweig 6 aus einer Reihenschaltung von zwei so genannten IGBTs 7 besteht. Jedem IGBT 7 ist eine Freilaufdiode 8 gegensinnig parallel geschaltet. Das aus den steuerbaren Leistungshalbleitern 7 sowie den gegensinnigen Dioden 8 bestehende Bauteil zusammen mit der Steuerelektronik wird im Folgenden als Leistungselektronik bezeichnet. Die Leistungselektronik ist dem Kondensator 5 parallel geschaltet. In Figur 2 sind ferner eine erste Anschlussklemme 9 sowie eine zweite Anschlussklemme 10 erkennbar, wobei die erste Anschlussklemme 9 mit dem Emitter des steuerbaren Leistungshalbleiters 7 und gleichzeitig mit der Anode der diesem zugeordneten gegensinnigen Diode 8, also mit anderen Worten mit deren Verbindungspunkt, verbunden ist. Die zweite Anschlussklemme 10 ist mit dem Verbindungspunkt der steuerbaren Leistungshalbleiter 7 sowie mit dem Verbindungspunkt der gegensinnigen Dioden 8 verbunden. Befindet sich der zwischen den Anschlussklemmen 9 und 10 angeordnete steuerbare Leistungshalbleiter 7 in seiner Durchgangsstellung, fällt an den Anschlussklemmen 9 und 10 die Spannung null ab. Befindet sich der besagte Leistungshalbleiter hingegen in seiner Sperrstellung, der nicht zwischen den Anschlussklemmen 9 und 10 angeordnete steuerbare Leistungshalbleiter 7 jedoch in seiner Durchgangsstellung, fällt zwischen den Anschlussklemmen 9 und 10 die an dem Kondensator 5 anliegende Spannung ab. Figur 3 zeigt eine alternative Ausgestaltung des Leistungshalbleitermoduls 2 gemäß Figur 2. Im Gegensatz zu der in Figur 2 gezeigten Variante einer Marquardt-Schaltung ist in Figur 3 die erste Anschlussklemme 9 mit dem Kollektor des abschaltbaren Leistungshalbleiters 7 und mit der Kathode der hierzu parallelen gegensinnigen Freilaufdiode 8 verbunden. Die zweite Anschlussklemme 10 ist mit dem Verbindungspunkt der abschaltbaren Leistungshalbleiter 7 und der Freilaufdioden 8 verbunden. Die in den Figuren gezeigten Ausführungsbeispiele der Marquardt-Schaltung sind zueinander äquivalent und weisen daher die gleichen Eigenschaften auf.

Figur 4 zeigt ein Leistungshalbleitermodul 2, das viele Merkmale des erfindungsgemäßen Leistungshalbleitermoduls gemäß Anspruchs 1 aufweist. Es ist erkennbar, dass das Leistungshalbleitermodul 2 neben dem steuerbaren Leistungshalbleitern 7 und den Anschlussklemmen 9 und 10 auch ein Gehäuse 11 aufweist, das in dem gezeigten Ausführungsbeispiel aus einem Metall, wie Stahlblech, besteht. In dem Gehäuse 11 sind ferner zwei Abgaskanäle 12 verdeutlicht, die zu den Anschlussklemmen 9 und 10 hin teilweise offen liegen. Bei einem in dem Gehäuse 10 auftretenden Lichtbogen werden die Heißgase daher durch die Abgaskanäle 12 nach außen geführt, wobei die Mündung der Abgaskanäle 12 so ausgerichtet ist, dass eine Beschädigung von Bauteilen, die außerhalb des Gehäuses 11 angeordnet sind, sicher vermieden werden kann. Zur Abkühlung der Heißgase ist in den Abgaskanälen 12 weiterhin ein Metallschaum mit einer großen inneren Oberfläche angeordnet. Mit anderen Worten ist der Metallschaum offenporig, so dass er von den Heißgasen oder anderen Explosionsgasen durchströmbar ist. Dabei kommt es aufgrund der großen Oberfläche zu einer großen Wärmeaustauschfläche und zu einem großen Temperaturaustausch zwischen dem Metallschaum und den austretenden Heißgasen, die auf diese Weise abgekühlt werden. Darüber hinaus verhindert der Metallschaum das Austreten von Partikeln, wobei zusätzlich eine Druckentlastung bereitgestellt ist.

## Patentansprüche

1. Leistungshalbleitermodul (2) für die Energieverteilung mit wenigstens einem Leistungshalbleiter (7), Anschlussklemmen (9,10) zum Anschluss des Leistungshalbleitermoduls (2) und einem Gehäuse (11), wobei jede Anschlussklemme (9,10) bis auf ihre freien Enden und jeder Leistungshalbleiter (7) in dem Gehäuse (11) angeordnet sind, wobei
das Gehäuse (11) einen nach außen führenden Abgaskanal (12) zum kontrollierten Abführen von Heißgasen und/oder Plasma im Explosionsfall aufweist, **dadurch gekennzeic hnet**, dass
der Abgaskanal (12) mit einem durchströmbaren temperaturfesten Füllstoff befüllt ist, so dass der Füllstoff in der Lage ist, den bei Lichtbogenbildung entstehenden hohen Temperaturen weitestgehend schadenfrei stand zu halten, wobei der temperaturfeste Füllstoff eine ein Metallfadenknäuel bildende Metallwolle ist.

2. Leistungshalbleitermodul (2) nach einem der vorhergehenden Ansprüche,
**dadurch gekennzeichnet, dass** das Gehäuse (11) ein Kunststoffgehäuse oder eine Metallgehäuse ist.

3. Leistungshalbleitermodul (2) nach einem der vorhergehenden Ansprüche,
**dadurch gekennzeichnet, dass** die Leistungshalbleiter (7) abschaltbare Leistungshalbleiter (7) umfassen.

4. Leistungshalbleitermodul (2) nach einem der vorhergehenden Ansprüche,
das durch
eine erste Anschlussklemme (9), eine zweite Anschlussklemme (10), einen Energiespeicher (5) und einen zwei in Reihe geschaltete steuerbare Leistungshalbleiter (7) aufweisenden Leistungshalbleiterzweig (6) in Parallelschaltung zum Energiespeicher (5) gekennzeichnet ist, wobei jedem steuerbaren Leistungshalbleiter (7) eine gegensinnige Freilaufdiode (8) parallel geschaltet ist und der Verbindungspunkt des Emitters eines ersten steuerbaren Leistungshalbleiters (7) des Leistungshalbleiterzweiges (6) und der Anode der dem ersten steuerbaren Leistungshalbleiter (7) zugeordneten gegensinnigen Freilaufdiode (8) die erste Anschlussklemme (9) und der Verbindungspunkt der steuerbaren Leistungshalbleiter (7) des Leistungshalbleiterzweiges (6) und der Freilaufdioden (8) die zweite Anschlussklemme (10) ausbilden.

5. Leistungshalbleitermodul nach einem der Ansprüche 1 und 2, **gekennzeichnet durch**
eine erste Anschlussklemme (9), eine zweite Anschlussklemme (10), einen Energiespeicher (5) und einen zwei in Reihe geschaltete steuerbare Leistungshalbleiter (7) aufweisenden Leistungshalbleiterzweig (6) in Parallelschaltung zum Energiespeicher (5), wobei jedem steuerbaren Leistungshalbleiter (7) eine gegensinnige Freilaufdiode (8) parallel geschaltet ist und der Verbindungspunkt des Kollektors eines ersten steuerbaren Leistungshalbleiters (7) des Leistungshalbleiterzweiges (6) und der Kathode der dem ersten steuerbaren Leistungshalbleiter (7) zugeordneten gegensinnigen Freilaufdiode (8) die erste Anschlussklemme (9) und der Verbindungspunkt der steuerbaren Leistungshalbleiter (7) des Leistungshalbleiterzweiges (6) und der Freilaufdiode (8) die zweite Anschlussklemme (10) ausbilden.

6. Stromrichterventilzweig (1) mit einer Reihenschaltung aus Leistungshalbleitermodulen (2) gemäß einem der vorhergehenden Ansprüche.

7. Stromrichter mit einer Brückenschaltung aus Stromrichterventilzweigen (1) gemäß Anspruch 6.

## Claims

1. Power semiconductor module (2) for energy distribution comprising at least one power semiconductor (7), connection terminals (9, 10) for connection of the power semiconductor module (2), and a housing (11), wherein each connection terminal (9, 10) apart from its free ends and each power semiconductor (7) are arranged in the housing (11), wherein the housing (11) has an exhaust gas channel (12), leading outside, for the controlled carrying away of hot gases and/or plasma in the event of an explosion, **characterized in that** the exhaust gas channel (12) is filled with a thermostable filler through which a flow can pass, such that the filler is able to withstand the high temperatures that arise during arcing in a manner free of damage to the greatest possible extent, wherein the thermostable filler is a metal wool that forms a tangle of metal filaments.

2. Power semiconductor module (2) according to any of the preceding claims,
**characterized in that**
the housing (11) is a plastic housing or a metal housing.

3. Power semiconductor module (2) according to any of the preceding claims,
**characterized in that**
the power semiconductors (7) comprise turn-off power semiconductors (7).

4. Power semiconductor module (2) according to any of the preceding claims,
which is **characterized by** a first connection terminal (9), a second connection terminal (10), an energy store (5) and a power semiconductor branch (6) connected in parallel with the energy store (5), said power semiconductor branch having two series-connected controllable power semiconductors (7), wherein a freewheeling diode (8) that is connected in the opposite sense is connected in parallel with each controllable power semiconductor (7) and the junction point of the emitter of a first controllable power semiconductor (7) of the power semiconductor branch (6) and the anode of the freewheeling diode (8) that is connected in the opposite sense and is assigned to the first controllable power semiconductor (7) forms the first connection terminal (9) and the junction point of the controllable power semiconductors (7) of the power semiconductor branch (6) and the freewheeling diodes (8) forms the second connection terminal (10).

5. Power semiconductor module according to either of Claims 1 and 2, **characterized by** a first connection terminal (9), a second connection terminal (10), an energy store (5) and a power semiconductor branch (6) connected in parallel with the energy store (5), said power semiconductor branch having two series-connected controllable power semiconductors (7), wherein a freewheeling diode (8) that is connected in the opposite sense is connected in parallel with each controllable power semiconductor (7) and the junction point of the collector of a first controllable power semiconductor (7) of the power semiconductor branch (6) and the cathode of the freewheeling diode (8) that is connected in the opposite sense and is assigned to the first controllable power semiconductor (7) forms the first connection terminal (9) and the junction point of the controllable power semiconductors (7) of the power semiconductor branch (6) and the freewheeling diode (8) forms the second connection terminal (10).

6. Converter valve branch (1) comprising a series circuit formed by power semiconductor modules (2) according to any of the preceding claims.

7. Converter comprising a bridge circuit formed by converter valve branches (1) according to Claim 6.

## Revendications

1. Module (2) à semi-conducteur de puissance pour la distribution d'énergie, comprenant au moins un semi-conducteur (7) de puissance, des bornes (9, 10) de connexion du module (2) à semi-conducteur de puissance et un boîtier (11), chaque borne (9, 10) de connexion, à l'exception de son extrémité libre, et chaque semi-conducteur (7) de puissance étant disposés dans le boîtier (11), dans lequel le boîtier (11) a un canal (12) pour des gaz perdus menant à l'extérieur pour évacuer de manière contrôlée des gaz chauds et/ou du plasma en cas d'explosion, **caractérisé en ce que** le canal (12) pour les gaz perdus est empli d'une charge résistante à la température et pouvant être traversée, de manière à ce que la charge soit en mesure de tenir, pour une grande partie sans dommage, à des températures hautes créées lors de la formation d'un arc électrique, la charge résistante à la température étant une laine métallique formant une pelote de fil métallique.

2. Module (2) à semi-conducteur de puissance suivant l'une des revendications précédentes,
**caractérisé en ce que**
le boîtier (11) est un boîtier en matière plastique ou un boîtier métallique.

3. Module (2) à semi-conducteur de puissance suivant l'une des revendications précédentes,
**caractérisé en ce que**
les semi-conducteurs (7) de puissance comprennent des semi-conducteurs (7) de puissance.

4. Module (2) à semi-conducteur de puissance suivant l'une des revendications précédentes,
qui est caractérisé en une première borne (9), une deuxième borne (10), un accumulateur (5) d'énergie et une branche (6) à semi-conducteur de puissance, ayant deux semi-conducteurs (7) de puissance montés en série et pouvant être commandés, la branche étant montée en parallèle à l'accumulateur (5) d'énergie, dans lequel, avec chaque semi-conducteur (7) de puissance, pouvant être commandé, est montée, tête-bêche en parallèle, une diode (8) de roue libre et le point de liaison de l'émetteur d'un premier semi-conducteur (7) de puissance, pouvant être commandé, de la branche (6) à semi-conducteur de puissance et l'anode de la diode (8) de roue libre, tête-bêche, associée au premier semi-conducteur (7) de puissance, pouvant être commandé, forme la première borne (9) et le point de liaison du semi-conducteur (7) de puissance, pouvant être commandé, de la branche (6) à semi-conducteur de puissance et de la diode (8) de roue libre, forme la deuxième borne (10).

5. Module (2) à semi-conducteur de puissance suivant l'une des revendications 1 et 2,
**caractérisé en ce qu'**
une première borne (9), une deuxième borne (10), un accumulateur (5) d'énergie et une branche (6) à semi-conducteur de puissance, ayant deux semi-conducteurs (7) de puissance pouvant être commandés montés en série, sont montés en parallèle à l'accumulateur (5) d'énergie, avec chaque semi-conducteur (7) de puissance, pouvant commandé, est montée, en parallèle, tête-bêche, une diode (8) de roue libre, et le point de liaison du collecteur d'un premier semi-conducteur (7) de puissance, pouvant être commandé, de la branche (6) à semi-conducteur et de la cathode de la diode (8) de roue libre, tête-bêche, associée au premier semi-conducteur (7) de puissance, pouvant être commandé, forme la première borne (9) et le point de liaison du premier semi-conducteur (7) de puissance, pouvant être commandé, de la branche (6) à semi-conducteur de puissance et de la diode (8) de roue libre, la deuxième borne (10).

6. Branche (1) de soupape de convertisseur de courant, comprenant un circuit série, composé de modules (2) à semi-conducteur de puissance suivant l'une des revendications précédentes.

7. Convertisseur de courant, ayant un circuit en pont composé de branches (1) de soupape de convertisseur de courant suivant la revendication 6.
